Europäisches Patentamt

European Patent Office

Office européen des brevets

(19)

(11) Numéro de publication : **0 045 258**

**B1**

(12) **FASCICULE DE BREVET EUROPÉEN**

(45) Date de publication du fascicule du brevet :
30.10.85

(51) Int. Cl.⁴ : **H 01 L 31/02, H 01 L 31/06**

(21) Numéro de dépôt : **81401195.3**

(22) Date de dépôt : **24.07.81**

(54) **Détecteur photovoltaïque sensible dans l'infrarouge proche.**

(30) Priorité : 30.07.80 FR 8016788

(43) Date de publication de la demande :
03.02.82 Bulletin 82/05

(45) Mention de la délivrance du brevet :
30.10.85 Bulletin 85/44

(84) Etats contractants désignés :
DE GB NL

(56) Documents cités :
FR-A- 2 336 804
APPLIED PHYSICS, vol. 17, no. 1, septembre 1978,
Heidelberg, DE, G. FIORITO et al.: "Properties of Hg.
Implanted $Hg_{1-x}Cd_xTe$ Infrared Detectors ", pages
105-110
APPLIED PHYSICS LETTERS, vol. 23, no. 8, 15 octobre 1973, New York, US, J. MARINE et al. "Infrared
photovoltaic detectors from ion-implanted
$Cd_xHg_{1-x}Te$ ", pages 450-452

(73) Titulaire : **SOCIETE ANONYME DE TELECOMMUNI-
CATIONS**
**40 avenue de New York**
**F-75116 Paris (FR)**

(72) Inventeur : **Pichard, Guy**
**4, Villa Provence**
**F-94430 Chennevieres (FR)**
Inventeur : **Royer, Michel**
**29, rue Claude Decaen**
**F-75012 Paris (FR)**

(74) Mandataire : **Bloch, Robert et al**
**39 avenue de Friedland**
**F-75008 Paris (FR)**

Jouve, 18, rue St-Denis, 75001 Paris, France

EP 0 045 258 B1

## Description

La présente invention concerne un détecteur photovoltaïque présentant une sensibilité maximale comprise entre 800 et 2 000 nm, du genre comprenant un substrat en $Hg_{1-x}Cd_xTe$ de type P, x étant choisi en fonction de la réponse spectrale désirée, et une zone de type N étant formée dans le substrat, ainsi que son procédé de fabrication. De tels détecteurs sont par exemple connus de FR-A-2 336 804.

Dans les détecteurs photovoltaïques, il est souhaitable que le temps de réponse soit le plus faible possible. Cela est essentiel en particulier lorsqu'on utilise de tels détecteurs pour détecter les signaux lumineux transmis par des fibres optiques, le débit numérique dans ce type de liaisons étant extrêmement élevé.

On sait d'autre part que l'atténuation dans la transmission par fibre optique est minimale pour une longueur d'onde de 1 300 nm et/ou de 1 600 nm, et il s'agit donc de mettre au point un détecteur sensible à ces longueurs d'onde et présentant les caractéristiques de réponse requises.

L'invention a pour objet un détecteur photovoltaïque du genre défini ci-dessus, caractérisé par le fait que x est compris entre 0,4 et 0,9, la concentration des porteurs P dans le substrat est inférieure à $10^{15}/cm^3$, et une zone intrinsèque I relativement épaisse est formée entre les zones N(6) et P(1).

Du fait de la pureté ainsi très élevée du substrat, et de la structure particulière du composé ternaire $Hg_{1-x}Cd_xTe$, qui comporte des lacunes de mercure et/ou de cadmium, l'introduction d'un agent dopant en concentration appropriée aboutit à la création d'une zone intermédiaire entre la zone P et la zone N, dont la concentration de porteurs est intrinsèque et de l'ordre de $10^{13}/cm^3$, pour constituer une jonction dite PIN. Une telle jonction, étant donné son très faible dopage et son épaisseur relativement importante, possède une capacité très faible et le détecteur présente ainsi un temps de réponse très court et peut fonctionner sous une tension de polarisation inverse élevée.

Pour former la zone N, on utilisera de préférence du mercure comme agent dopant, et on procédera à une diffusion thermique du mercure selon la technique planar, conformément à l'enseignement du brevet français 2 336 804.

Un autre procédé utilisable est l'implantation ionique d'atomes possédant, après un recuit approprié, une activité électrique de type N, tels que des atomes d'indium, d'aluminium ou de bore.

L'invention sera bien comprise à la lecture de la description ci-après faite en référence aux dessins annexés.

Dans les dessins :

les figures 1 à 7 illustrent les différentes phases d'un mode de fabrication du détecteur photovoltaïque selon l'invention ;

la figure 8 montre la réponse spectrale d'un détecteur selon l'invention ;

la figure 9 montre la caractéristique tension-courant de ce détecteur.

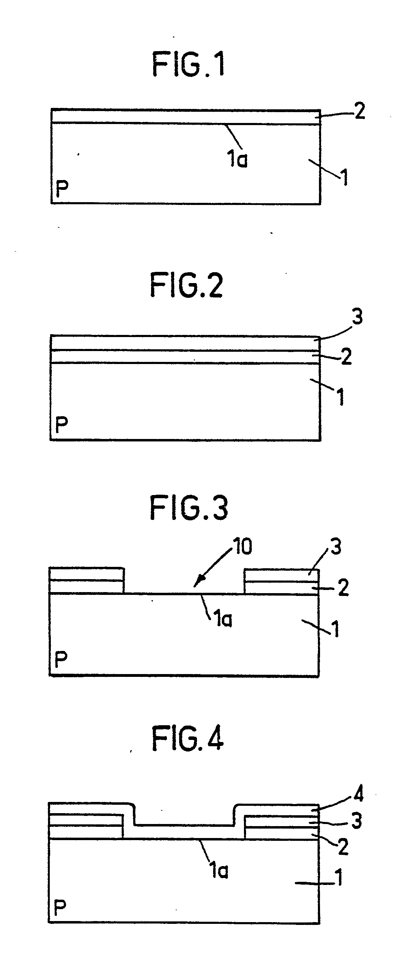

Les figures 1 à 7 illustrent la fabrication d'un détecteur photovoltaïque selon l'invention selon le procédé décrit dans le brevet français 2 336 804.

Le présent exemple concerne un détecteur dont la sensibilité maximale se situe à 1 300 nm. Le substrat du détecteur est constitué d'un alliage $Hg_{1-x}Cd_xTe$ dans lequel la proportion x de cadmium est d'environ 0,7.

On part d'un substrat 1, de type P (cf. figure 1) formé d'un cristal de $Hg_{1-x}Cd_xTe$ de très haute pureté, présentant donc une concentration en porteurs P très faible, de l'ordre de $10^{15}/cm^3$. Un tel cristal peut être obtenu par la méthode dite THM (Travel Heater Method), consistant à déplacer un lingot de HgTe et un lingot de CdTe par rapport à une zone chauffée dans laquelle un solvant tel que le tellure dissout les deux lingots. On obtient à la sortie de la zone de solvant un lingot unique de $Hg_{1-x}Cd_xTe$ de haute pureté, dans lequel la valeur x est fonction des sections des lingots de départ. Un tel procédé est décrit dans un article de R. Triboulet intitulé « CdTe and CdTe : Hg alloys cristal growth using stoichiometric and off-stoichiometric zone passing techniques », paru dans la Revue de Physique Appliquée, tome 12, février 1977, page 123.

Sur le substrat 1, on dépose une couche 2 de CdTe, par exemple par pulvérisation cathodique. Puis on dépose sur la couche 2 une couche de masquage 3 (figure 2), de préférence en ZnS, SiO ou $SiO_2$. On soumet ensuite l'élément de la figure 2 à un traitement thermique à une température comprise entre 200 et 400 °C, de façon à recristalliser la couche 2 et à lui donner une composition qui varie graduellement, la couche 2 ayant une composition identique à celle du substrat 1 à l'interface avec celui-ci et étant composée de CdTe pur à l'interface avec la couche 3 de ZnS, SiO ou $SiO_2$.

Après ce traitement thermique, on réalise au moins une ouverture 10 dans les couches 2 et 3 de façon à mettre à nu une partie de la surface 1a du substrat (figure 3), puis on dépose au moins dans l'ouverture 10 une couche 4 de CdTe (figure 4).

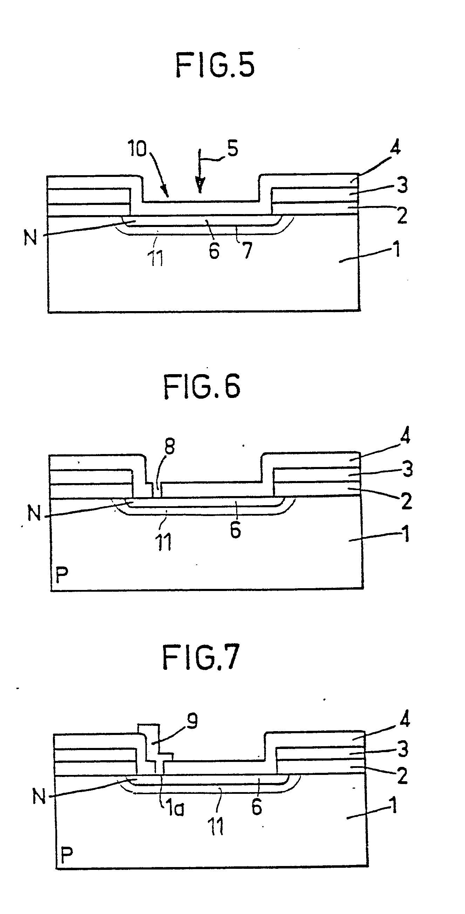

Ensuite, on fait diffuser du mercure (flèche 5, figure 5) dans le substrat à travers la couche 4 de CdTe. Celle-ci est perméable au mercure à la température de diffusion, supérieure à 300 °C. On obtient ainsi une zone 6 de type N, de dopage environ $10^{16}$ atomes/$cm^3$, qui forme avec le substrat P une jonction 7. Comme on l'a expliqué ci-dessus, cette jonction est une jonction PIN, car elle comporte une zone 11 à faible dopage ($10^{13}/cm^3$) dite zone intrinsèque, relativement épaisse, entre le substrat P et la zone N.

On pratique ensuite une ouverture 8 dans la couche 4 par attaque chimique, et on remplit cette ouverture avec un métal conducteur tel que Al ou In afin de réaliser un contact 9.

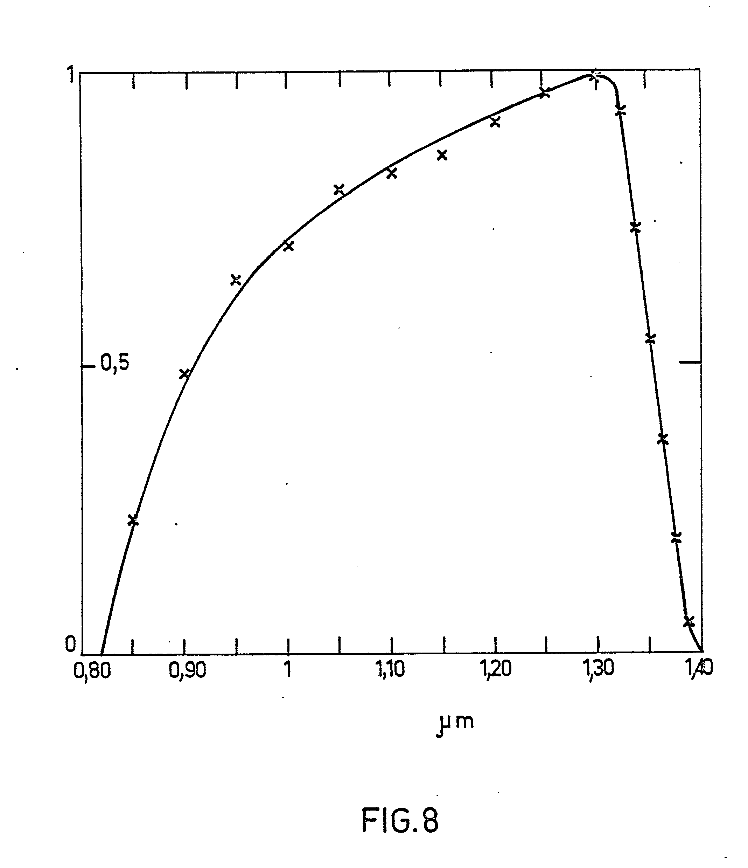

Le détecteur photovoltaïque obtenu présente la réponse spectrale représentée à la figure 8. La bande de sensibilité va de 900 à 1 350 nm, avec un maximum à 1 300 nm. La courbe de la figure 8 donne la réponse spectrale à la température ambiante (T = 300 °K) et en l'absence de polarisation.

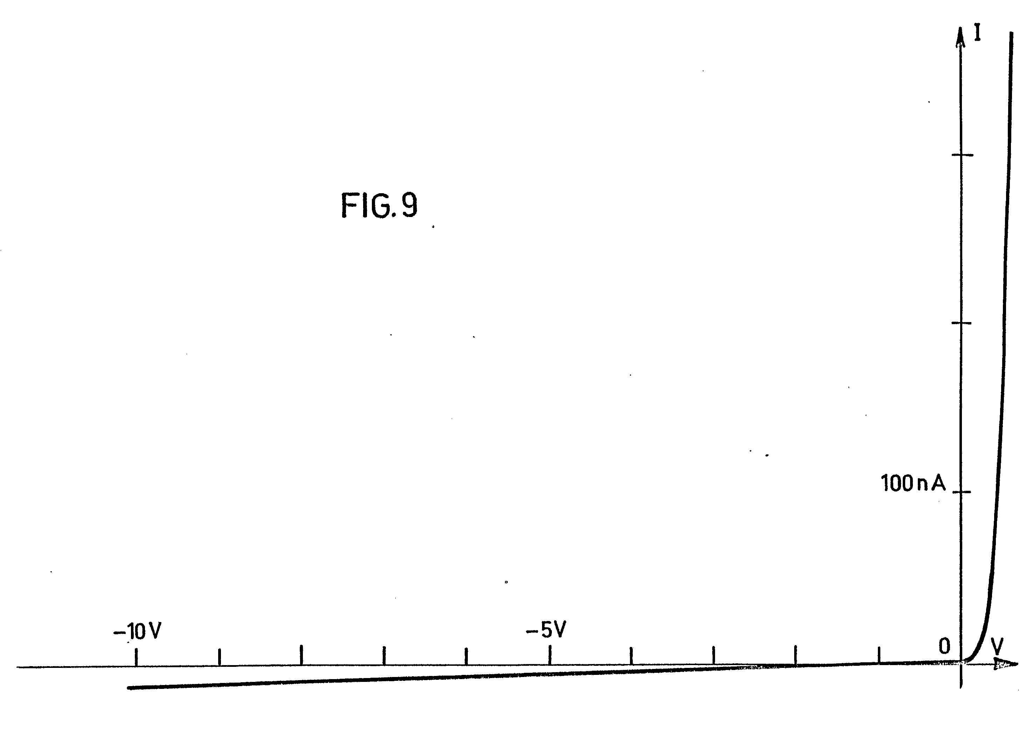

Un exemple de la caractéristique IV (tension-courant) est donné à la figure 9 pour un détecteur d'une surface sensible de $3 \cdot 10^{-4}$ cm$^2$.

Les caractéristiques du détecteur sont les suivantes :

| | |
|---|---|
| tension d'avalanche (à I = 10 μA) | > 70 V |
| courant de saturation | < 1 nA |
| courant inverse (V = − 10 volts) | 10 nA |
| capacité totale (V = − 10 volts) | < 1 pF |
| capacité de jonction (V = − 10 volts) | < 0,1 pF |
| produit résistance-surface (V = 0 volt) | $6 \cdot 10^4 \, \Omega \text{cm}^2$ |
| réponse en courant à λ = 1 300 nm | > 0,5 A/W |
| gain interne à V = − 10 volts | > 5 |

Le détecteur décrit présente une constante de temps de réponse inférieure à 1 nanoseconde pour une polarisation inverse égale à − 10 V, ou encore, une bande passante à − 3 dB supérieure à 500 MHz.

Un autre exemple de réalisation, pour un détecteur d'une surface sensible de $1 \cdot 10^{-4}$ cm$^2$, est donné par le tableau ci-dessous :

| | |
|---|---|
| Température de fonctionnement | T = 300 °K |
| Surface sensible | $1 \times 10^{-4}$ cm$^2$ |
| Etendue spectrale | 900-1 300 nm |
| Responsivité | ⩾ 0,8 A/W |
| Produit résistance-surface (v = 0 volt) | $6 \times 10^{-4} \, \Omega \text{cm}^2$ |
| Courant d'obscurité (v = − 10 volts) | ⩽ 1 nA |
| Tension d'avalanche | ⩾ 70 V |
| Capacité totale (v = − 10 volts) | < 1 pF |
| Temps de montée (v = − 10 volts) | < 1 ns |
| Bande passante (v = − 10 volts) | > 500 MHz |

Les détecteurs décrits présentent un maximum de sensibilité à 1 300 nm. Si l'on désire obtenir un détecteur présentant une réponse spectrale différente, par exemple avec un maximum à 1 600 nm, on partira simplement d'un substrat de composition différente. La variation de la réponse spectrale en fonction des proportions de cadmium et de mercure dans l'alliage $Hg_{1-x}Cd_xTe$ est en soi une donnée bien connue.

**Revendications**

1. Détecteur photovoltaïque présentant une sensibilité maximale comprise entre 800 et 2 000 nm, du genre comprenant un substrat en $Hg_{1-x}Cd_xTe$ de type P, x étant choisi en fonction de la réponse spectrale désirée, et une zone de type N étant formée dans le substrat, caractérisé par le fait que x est compris entre 0,4 et 0,9, la concentration des porteurs P dans le substrat est inférieur à $10^{15}/\text{cm}^3$, et une zone intrinsèque I relativement épaisse est formée entre les zones N(6) et P(1).

2. Procédé de fabrication d'un détecteur photovoltaïque selon la revendication 1 caractérisé par le fait que les zones N et I sont formées par diffusion thermique de mercure à travers une couche de CdTe.

3. Procédé de fabrication d'un détecteur photovoltaïque selon la revendication 1 caractérisé par le fait que les zones N et I sont formées par implantation ionique d'indium, d'aluminium ou de bore.

**Claims**

1. Photovoltaic detector having its maximum sensitivity between 800 and 2 000 nm, of the type comprising a P type substrate made of $Hg_{1-x}Cd_xTe$, x being selected as a function of the desired spectral response and a N type zone being formed in the substrate, characterized in that x is within a range of 0,4 to 0,9, the concentration of the P carriers in the substrate is less than $10^{15}/\text{cm}^3$, and an intrinsic zone I relatively which is formed between the zones N(6) and P(1).

2. Process for manufactoring a photovoltaic detector according to claim 1, characterized in that the zones N and I are formed by thermal diffusion of mercury through a layer of Cd Te.

3. Process for manufactoring a photovoltaic detector according to claim 1, characterized in that the zones N and I are formed by ionic implantation of indium, aluminium or boron.

**Patentansprüche**

1. Photovoltaischer Detektor mit einer maximalen Empfindlichkeit im Bereich zwischen 800 und 2 000 nm von der Art die ein Substrat aus $Hg_{1-x}Cd_xTe$ vom P-Typ aufweist, wobei x in Abhängigkeit von der gewünschten Spektralkurve gewählt ist und im Substrat eine Zone vom N-Typ ausgebildet ist, dadurch gekennzeichnet, daß x zwischen 0,4 und 0,9 liegt, die Konzentration der Träger P im Substrat niedriger als $10^{15}/cm^3$ ist und zwischen den Zonen N(6) und P(1) eine relativ dicke Eigenzone I gebildet ist.

2. Verfahren zur Herstellung eines photovoltaischen Detektors nach Anspruch 1, dadurch gekennzeichnet, daß die Zonen N und I durch thermische Diffusion von Quecksilber durch eine Schicht aus CdTe gebildet werden.

3. Verfahren zur Herstellung eines photovoltaischen Detektors nach Anspruch 1, dadurch gekennzeichnet, daß die Zonen N und I durch jonische Implantation von Indium, Aluminium oder Bor gebildet werden.

# FIG.1

P

1a

2

1

# FIG.2

3

2

1

P

# FIG.3

10

3

2

1a

1

P

# FIG.4

4

3

2

1a

1

P

# FIG.5

# FIG.6

# FIG.7

FIG.8

FIG.9